# EUROPEAN PATENT APPLICATION

(11) **EP 4 550 195 A1**
(43) Date of publication of application: **07.05.2025**
(21) Application number: 24210441.2
(22) Date of filing: 02.11.2024
(51) Int. Cl.: G06F 30/12, G06F 30/17, G06F 30/23, G06T 19/20

(54) **FINITE ELEMENT MESH GENERATION BY MIRRORING**

(30) Priority: 03.11.2023 IN 202321075298; 07.02.2024 IN 202421008434; 30.08.2024 US 202418821446
(71) Applicant: Dassault Systemes Americas Corp., Waltham, MA 02451 (US)
(72) Inventor: DUPUIS, Nicolas, 78140 Vélizy-Villacoublay (FR); PETIT, Laurent, 78140 Vélizy-Villacoublay (FR); DAUSSE, Philippe, 78140 Vélizy-Villacoublay (FR); ALLAIN, Pierre-Louis, 78140 Vélizy-Villacoublay (FR); LATOURTE, Basile, 78140 Vélizy-Villacoublay (FR); SANKARAN, Narayan, Johnston, 02919 (US); M P, Anand, 411057 Pune (IN); MORE, Vikram, 411057 Pune (IN); VERUBHOTLA, Vajramohan, 411057 Pune (IN); JAISWAL, Ashwani, 411057 Pune (IN); RAMINI, Mahadevu, 411057 Pune (IN)
(74) Representative: Bandpay & Greuter

(57) **Abstract**

Embodiments provide functionality for generating finite element models (FEMs). An embodiment begins by obtaining a computer-aided design (CAD) model representing an assembly of parts and an indication of a symmetry plane within the CAD model. From amongst the assembly of parts, a source part and a corresponding mirror part are identified using the obtained CAD model and the indication of the symmetry plane. In turn, the source part is meshed to generate a FEM representing the source part and the FEM representing the source part is mirrored to generate a FEM representing the mirror part.

## Description

### BACKGROUND

A number of systems and programs are offered on the market for the design of parts using computer aided design (CAD), or computer aided engineering (CAE). These so-called CAD systems allow a user to construct and manipulate complex three-dimensional models of objects or assemblies of objects. CAD systems thus provide a representation of modeled objects using edges, lines, or, in certain cases, faces or polygons. Lines, edges, faces, or polygons may be represented in various manners, e.g., non-uniform rational basis splines (NURBS).

These CAD systems manage parts or assemblies of parts modeled by objects, which are mainly specifications of geometry. In particular, CAD files contain specifications, from which geometry is generated. From geometry, a representation is generated. Specifications, geometries, and representations may be stored in a single CAD file, or multiple CAD files. CAD systems include graphic tools for representing the modeled objects to the designers; these tools are dedicated to the display of complex objects. For example, an assembly may contain thousands of parts. A CAD system can be used to manage models of objects, which are stored in electronic files.

The advent of CAD and CAE systems allows for a wide range of representation possibilities for objects. One such representation is a finite element model (FEM). A FEM, or other such CAD, CAE, or computer-based model, may be programmed in such a way that the model has the properties of the underlying object or objects that the model represents. When a FEM, or other such computer-based model is programmed in such a way, it may be used to perform simulations of the object that the model represents. For example, a FEM may be used to represent the interior cavity of a vehicle, the acoustic fluid surrounding a structure, and any number of real-world objects and systems. When a given model represents an object and is programmed accordingly, it may be used to simulate the real-world object itself. For example, a FEM representing a stent may be used to simulate the use of the stent in a real-life medical setting.

Computer-based models, e.g., FEMs, may be used to improve the design of the objects that the models represent. Design improvements may be identified through use of computer-based optimization techniques that run a series of simulations in order to identify changes to the design of the model and thus, the underlying real-world object that the model represents.

### SUMMARY

While the use of computer-based models is prevalent, e.g., in optimization methods to improve the design of real-world objects represented by the models, existing computer-based modeling techniques could benefit from improvements. Embodiments provide such functionality, namely improvements to existing methods for generating Finite Element Models (FEMs). Embodiments offer substantial benefits to users by automating the generation of FEMs, e.g., FEMs representing large assemblies, such as airplanes and automobiles. Embodiments provide improvements to data modelling and process efficiency and provide performance and time savings.

An example embodiment is directed to a computer-implemented method of generating a FEM. The method begins by a processor, obtaining, in memory of the processor, a CAD model representing an assembly of parts, and an indication of a symmetry plane within the CAD model. From amongst the assembly of parts, the processor identifies a source part and corresponding mirror part, where the source part and the mirror part are identified using the obtained CAD model and the indication of the symmetry plane. To continue, the processor meshes the source part to generate a FEM representing the source part and mirrors the FEM representing the source part to generate a FEM representing the mirror part.

In an embodiment, at least one of the meshing and the mirroring are performed automatically responsive to identifying the source part and the corresponding mirror part.

In another embodiment, at least one of the meshing and the mirroring are performed responsive to a user input. According to an embodiment, the user input is at least one of: the indication of the symmetry plane, an indication to perform the obtaining, the identifying, the meshing, and the mirroring, and an indication of a candidate source part. In another embodiment, identifying the source part comprises identifying the source part using the indication of the candidate source part.

Another embodiment includes at least one of: (i) associating, in the memory, a representation of the source part in the CAD model and the FEM representing the source part and (ii) associating, in the memory, a representation of the mirror part in the CAD model and the FEM representing the mirror part. In yet another embodiment, responsive to modifying the representation of the source part in the CAD model, the method automatically modifies the FEM representing the source part and the FEM representing the mirror part. In another embodiment, responsive to modifying the FEM representing the source part, the method automatically modifies the FEM representing the mirror part. Another embodiment includes receiving indications of (i) a selected element of the representation of the mirror part in the CAD model and (ii) one or more simulation features to apply to the selected element. Based on the associating, in the memory, of the representation of the mirror part in the CAD model and the FEM representing the mirror part, the embodiment identifies one or more elements of the FEM representing the mirror part corresponding to the selected element of the representation of the mirror part in the CAD model. Such an embodiment, in turn, applies the one or more simulation features to the identified one or more elements of the FEM representing the mirror part and performs a simulation utilizing the FEM representing the mirror part with the one or more features applied. In a further embodiment, the associating of the representation of the mirror part in the CAD model and the FEM representing the mirror part within the memory includes linking, in the memory, (i) the representation of the mirror part in the CAD model and the representation of the source part in the CAD model, (ii) the representation of the source part in the CAD model and elements of the FEM representing the source part, and (iii) the elements of the FEM representing the source part and elements of the FEM representing the mirror part.

Another example embodiment is directed to a system for generating a FEM. The system includes a processor and a memory with computer code instructions stored thereon. The processor and the memory, with the computer code instructions, are configured to cause the system to implement any embodiments or combination of embodiments described herein.

Yet another example embodiment is directed to a computer program product for generating a FEM. The computer program product includes one or more non-transitory computer-readable storage devices and program instructions stored on at least one of the one or more storage devices. In such an embodiment, the program instructions, when loaded and executed by a processor, cause an apparatus associated with the processor to perform the method of any embodiments or combination of embodiments described herein.

It is noted that embodiments of the method, system, and computer program product may be configured to implement any embodiments, or combination of embodiments, described herein.

### BRIEF DESCRIPTION OF THE DRAWINGS

The foregoing will be apparent from the following more particular description of example embodiments, as illustrated in the accompanying drawings in which like reference characters refer to the same parts throughout the different views. The drawings are not necessarily to scale, emphasis instead being placed upon illustrating embodiments.
FIG. 1 is a graphical representation of a method for generating mirrored FEMs of identified parts according to an embodiment.
FIG. 2 is a flowchart of a method for generating a finite element model according to an embodiment.
FIG. 3 is a graphical illustration of a method to create CAD parts using a 3D modeling tool across a mirror plane.
FIG. 4 is a graphical illustration of a method of automatically generating a FEM of a CAD assembly utilizing mirroring across a mirror plane according to an embodiment.
FIG. 5 is a graphical illustration of a method for automatically detecting pairs of mirror parts in a CAD assembly for FEM mirroring based on an identified mirror plane according to an embodiment.
FIG. 6 is a graphical illustration of a method for automatically generating a FEM for both source parts and mirror parts responsive to identifying mirror parts.
FIG. 7 is a graphical illustration of a method for generating a FEM based upon a user-selected pre-existing FEM according to an embodiment.
FIG. 8 is a graphical illustration of a method of generating FEMs both automatically and based upon user input according to an embodiment.
FIG. 9 is a graphical illustration of a method for implementing changes to FEMs according to an embodiment.
FIG. 10 illustrates a computer network or similar digital processing environment in which embodiments of the present disclosure may be implemented.
FIG. 11 is a diagram of an example internal structure of a computer in the computer system of FIG. 10, according to an embodiment.

### DETAILED DESCRIPTION

A description of example embodiments follows.

Embodiments provide innovative and time-efficient methods and systems for the automatic, comprehensive, and associative generation of simulation models, e.g., finite element models, for symmetric components within assemblies, e.g., extensive assemblies.

Computer-based design users are searching for ways to streamline operations and, ultimately, minimize time to market for the real-world objects being designed and optimized using CAD methods/techniques. In various industries, such as the automotive and aerospace industries, more than 20% of the parts in CAD assemblies representing the real-world objects being designed, e.g., cars and airplanes, are symmetric. Embodiments leverage this symmetry to improve efficiency in modeling real-world objects. Specifically, embodiments provide improved methods and systems for generating FEMs. Embodiments implement a solution that can quickly replicate a half of a symmetrical mesh of a model once an opposite half of the symmetrical mesh is modeled.

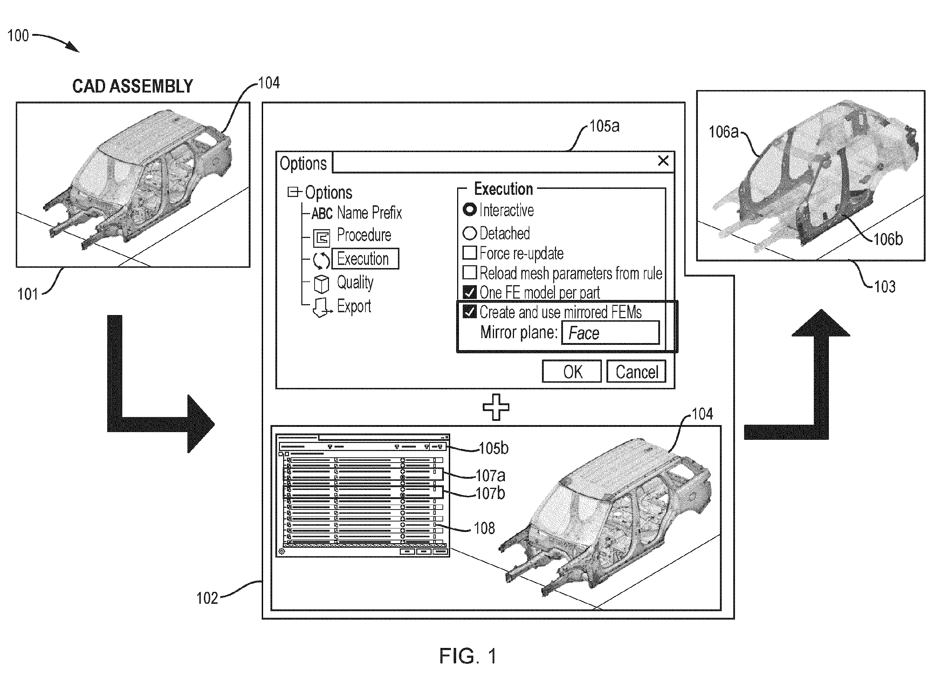

FIG. 1 is a graphical representation of a method 100 for generating mirrored FEMs of identified parts according to an embodiment. The method 100 starts at step 101 by obtaining a CAD assembly model 104. At step 102, interactive options are presented to a user, e.g., in graphical user interfaces 105a-b, to allow the user to customize operations of the FEM mirroring method 100. These options may be selecting parts of the model to be mirrored (105b) and selecting what to do with the selected parts (105a), i.e., to create mirrored parts across a symmetry plane. For example, in an embodiment, the user interface 105b is a primary user interface that allows users to (i) select domain parts of the model, e.g., 104, to be mirrored, (ii) execute the FEM generating process 100, (iii) execute the method 100 in parallel batch processes, and (iv) review detected mirror parts. Further, according to an embodiment, the user interface 105a is a sub-user interface that originates from settings within user interface 105b. Amongst other examples, user interface 105a allows users to customize whether mirror FEM generation is needed or not. Moreover, if FEM generation is needed, the user interface 105a allows users to customize the mirror plane based upon user selection in a mirror plane field. In the example depicted in FIG. 1, the interface 105b includes highlighted elements 107a-b indicating content for the user to review, e.g., to review the mirror pairs detected. The rows, e.g., 108, in the interface 105b list mirrored content identified with respect to a source part. Further still, at step 102, the user may identify a mirror plane or indicate symmetric parts across a mirror plane in the model 104 (that was obtained at step 101). "Symmetric parts" as used herein, may be used to refer to parts across a mirror plane which are substantially symmetrical, for example, 98% symmetrical across the mirror plane. To continue, at step 103, one or more FEMs of symmetric parts, e.g., 106a-b, (which may be automatically identified or identified based upon user input) are generated.

Embodiments of the method 100 may be implemented in CAE software, such as, for example, 3DEXPERIENCE^{®} provided by Applicant-Assignee Dassault Systemes Americas Corporation. In such embodiments, for instance, the interfaces presented at step 102 may be provided using functionality within 3DEXPERIENCE^{®}.

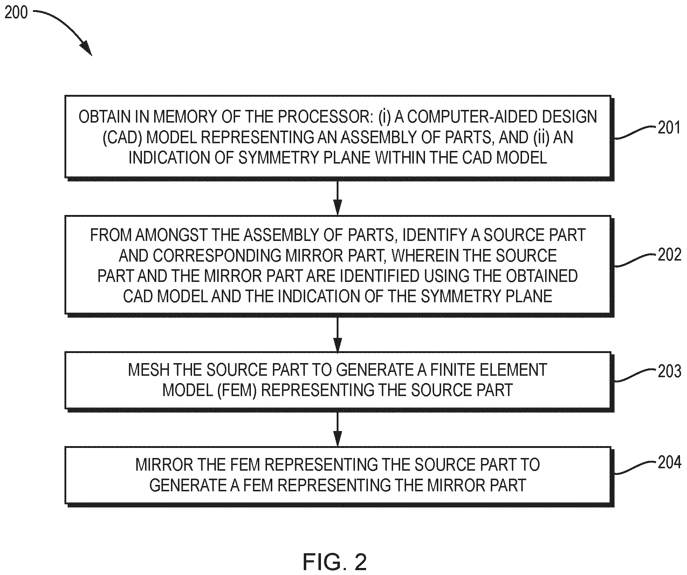

FIG. 2 is a flowchart of a method 200 for generating a finite element model, according to an embodiment. The method 200 begins at step 201 by obtaining in memory of a processor, (implementing the method), (i) a CAD model representing an assembly of parts, and (ii) an indication of a symmetry plane within the CAD model. To continue, at step 202, from amongst the assembly of parts, a source part and a corresponding mirror part are identified. The source part and the mirror part are identified at step 202 using the obtained CAD model and the indication of the symmetry plane. Next, at step 203, the source part is meshed to generate a FEM representing the source part. Subsequently at step 204, the FEM representing the source part is mirrored to generate a FEM representing the mirror part. In embodiments of the method 200, the generated FEMs may be solid meshes, surface meshes, and beam meshes for multiple bodies, amongst other examples.

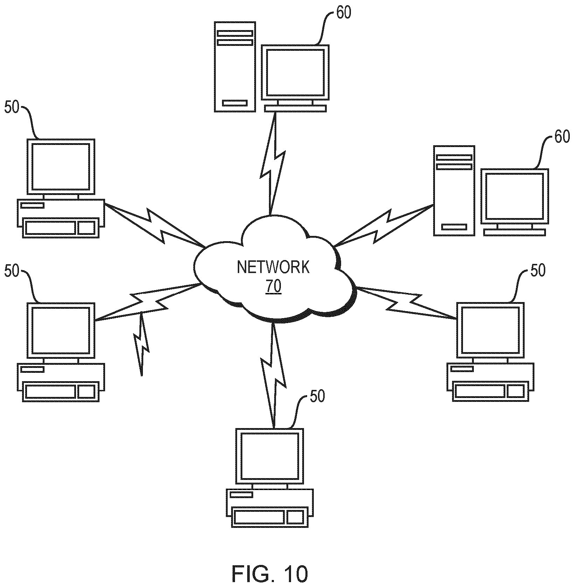

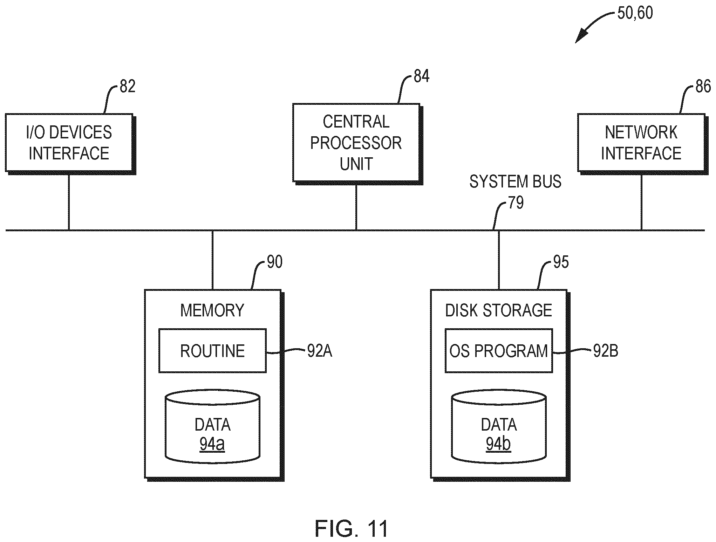

The method 200 is computer-implemented and, as such, the functionality and effective operations, e.g., the obtaining (201), identifying (202), meshing (203), and mirroring (204), are automatically implemented by one or more digital processors. Moreover, the method 200 can be implemented using any computer device or combination of computing devices known in the art. Among other examples, the method 200 can be implemented using computer(s)/device(s) 50 and/or 60 described hereinbelow in relation to FIGs. 10 and 11. Moreover, the method 200 and embodiments described herein may be implemented in existing computer-based design software. For instance, example embodiments may be implemented in 3DEXPERIENCE^{®} R2024x provided by Applicant-Assignee Dassault Systemes Americas Corporation. In such an embodiment, a Model Assembly Design application of 3DEXPERIENCE^{®} is enriched with embodiments to provide a powerful tool to mirror FEMs.

Embodiments of the method 200 can use geometry from any number of sources to generate the FEM. The method 200 is computer implemented and, as such, the CAD model may be obtained at step 201 from any point, e.g., data storage, communicatively coupled or capable of being communicatively coupled to a computing device implementing the method 200. Moreover, the model obtained at step 201can include, amongst other examples, any of the following: (i) part bodies, (ii) solid bodies, (iii) geometry from ordered geometric sets.

Further, at step 201, the indication of the symmetry plane within the CAD model may be obtained using any technique capable of communicating, i.e., indicating, the symmetry plane to a computing device implementing the method 200. For instance, the indication of the symmetry plane may be provided via a graphical user interface, or by using programming Application Programming Interfaces (APIs) that may be available to the user, e.g., via Component Application Architecture (CAA) or scripting APIs. In another embodiment, the indication of the symmetry plane is obtained by receiving, responsive to user input, coordinates of the symmetry plane in relation to a coordinate system of the obtained CAD model.

At step 202, embodiments of the method 200 may automatically identify the source part and mirror part using the obtained CAD model and indication of the symmetry plane. According to one such embodiment, the source part and mirror part are determined at step 202 by, first, for each part of the assembly of parts (or a subset thereof), generating a respective point cloud representing the part. Further, a mapping between point clouds and parts is also created for ultimately determining source parts and mirror parts. In turn, generated respective point clouds representing parts on a first side of the symmetry plane and generated respective point clouds representing parts on a second side of the symmetry plane are compared to identify symmetrical point clouds. In an embodiment, comparing point clouds includes comparing positions of points in the clouds on a first side of the symmetry plane and positions of points in the cloud on an opposite side of the symmetry plane. In such embodiment, point clouds are considered symmetrical when positions of points in the cloud on the first side of the plane of symmetry and positions of the points on the opposite side of the plane of symmetry mirror each other above a threshold, e.g., ninety percent. For each grouping of symmetrical point clouds one point cloud is considered a source point cloud and another point cloud is considered a mirror point cloud. The aforementioned mapping between point clouds and parts of the assembly is used along with the identified symmetrical point clouds to determine corresponding source parts and mirror parts. Specifically, source point clouds represent source parts and mirror point clouds represent mirror parts and the mapping is used to determine what point clouds represent what parts.

At step 203, embodiments of the method 200 may use any technique known to those of skill in the art to mesh the source part to generate the FEM representing the source part.

Further, according to an embodiment, at step 204 the FEM representing the source part may be mirrored using techniques known in the art. For example, in an embodiment, a meshing tool is used to handle the mesh data. In another embodiment, to perform the mirroring at step 204, the mesh elements on one side of the desired mirror plane may be selected and duplicated. Then, coordinates of the duplicated mesh elements may be transformed by reflecting them across the mirror plane, which involves changing the sign of the coordinates perpendicular to the mirror plane. After this transformation, orientations of the mesh elements, such as faces and volumes, may be adjusted. This adjustment ensures that the element normals and node orderings are correct, maintains the mesh's consistency, and prevents issues such as inverted normals or incorrect connectivity. At step 204, the method 200 makes a mirrored copy of the mesh that is accurately reflected across the mirror plane with elements correctly oriented to match the original mesh's topology and geometry. In embodiments of the method 200, planar symmetry of the mirror plane may be required at step 204 to convert a right-handed axis system into a left-handed one, and vice versa if necessary. However, left-handed coordinate systems pose technical and theoretical challenges (e.g., no quaternions) and are not ideal. Consequently, in an embodiment, each entity, including mesh topologies, material orientations, and beam orientations, is transformed into a standard right-handed system when performing the mirroring at step 204. To illustrate, in an embodiment, a FEM representing a source part (e.g., as generated at step 203) is modeled in a standard right-handed coordinate system. However, when the FEM representing the mirrored part is generated at step 204, the mirroring operation converts the right-handed coordinate system of the FEM representing the source part into a left-handed coordinate system for the FEM representing the mirrored part. Therefore, an embodiment converts the FEM representing the mirrored part in a left-handed coordinate system into a FEM representing the mirror part in a right-handed coordinate system. In this way, such an embodiment preserves the intent of the mirroring and avoids the technical difficulties caused by left-handed coordinate systems.

By mirroring the FEM representing the source part, embodiments avoid the computational burden of meshing both the source part and mirror part. As such, embodiments advantageously perform the meshing (e.g., through use of a meshing algorithm) one time and generate the FEM representing the mirror part by mirroring the FEM representing the source part.

Still referring to FIG. 2, in some embodiments, at least one of the meshing (step 203) and the mirroring (step 204) are performed automatically in response to the source part and corresponding mirror part being identified at step 202. In other embodiments, at least one of the meshing (step 203) and mirroring (step 204) are performed responsive to a user input. Amongst other examples, the user input may be any one of: (i) an indication of the symmetry plane, (ii) an indication to perform the obtaining (201), identifying (202), meshing (203), and mirroring (204), and (iii) an indication of a candidate source part. According to an embodiment, the source part is identified at step 202 using the indication of the candidate source part.

In embodiments, the method 200 may further include associating, in the memory, a representation of the source part in the CAD model and the FEM representing the source part, and/or associating, in the memory, a representation of the mirror part in the CAD model and the FEM representing the mirror part. According to an embodiment, these associations may include associations between CAD entities, e.g., faces, and entities of a FEM, e.g., nodes and edges representing the face. Embodiments of the method 200 may utilize the associations to automatically modify the FEM representing the source part and the FEM representing the mirror part responsive to modifying the representation of the source part in the CAD model. Further, such embodiments may automatically modify the FEM representing the mirror part responsive to modifying the FEM representing the source part.

Further still, embodiments of the method 200 may rely on the aforementioned associations to perform a simulation. In such an embodiment, mirror CAD elements and mirror FEM elements are associated, e.g., indicated/linked in memory as corresponding and, similarly, source CAD parts and elements in the FEM representing the source CAD parts are linked/associated. These associations allow such an embodiment to apply simulation features (e.g., loads, boundary conditions, constraints, properties, etc.) directly on elements of the FEM (e.g., the mirror FEM) corresponding to elements of a CAD part (e.g., the mirror CAD part). To implement such functionality, an embodiment of the method 200 receives indications of (i) a selected element, e.g., a CAD entity, of the representation of the mirror part in the CAD model, and (ii) one or more simulation features (e.g., load, boundary condition, etc.) to apply to the selected element. Based on the associating, in the memory, of the representation of the mirror part in the CAD model and the FEM representing the mirror part, the embodiment identifies one or more elements of the FEM representing the mirror part corresponding to the selected element of the representation of the mirror part in the CAD model. Further, this embodiment may apply the one or more simulation features to the identified one or more elements of the FEM representing the mirror part and perform a simulation utilizing the FEM representing the mirror part with the one or more features applied. In a further embodiment, the associating of the representation of the mirror part in the CAD model and the FEM representing the mirror part within the memory may include linking, in the memory, (i) the representation of the mirror part in the CAD model and the representation of the source part in the CAD model, (ii) the representation of the source part in the CAD model and elements of the FEM representing the source part, and (iii) the elements of the FEM representing the source part and elements of the FEM representing the mirror part.

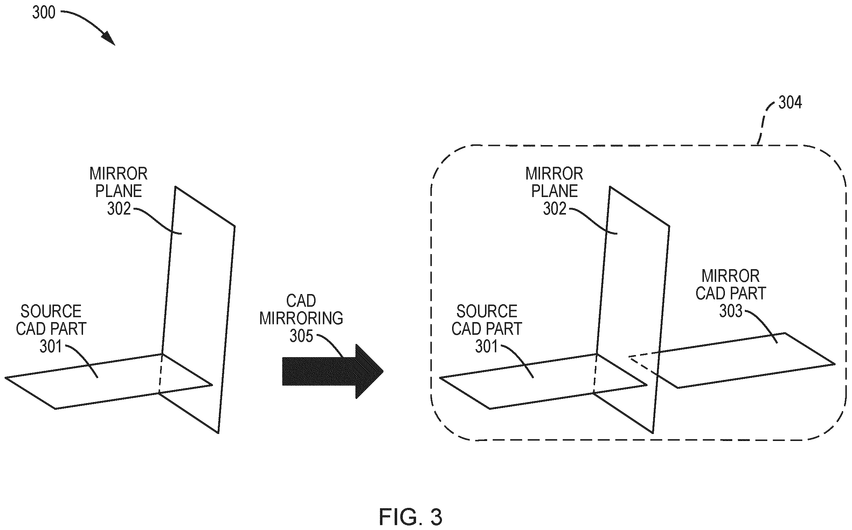

FIG. 3 is a graphical illustration of a method 300 for creating CAD parts, e.g., using a CAD modeling tool, such as for example 3DEXPERIENCE^{®}, across a mirror plane. The method 300 begins with identifying or otherwise obtaining a source CAD part 301 and a mirror plane 302. CAD mirroring 305 is then performed, e.g., utilizing the CAD modeling tool, to create a mirrored CAD part 303 across the mirror plane 302. The CAD part 303 is a mirror version of the CAD part 301. The mirroring 305 results in a CAD assembly 304 that includes both the source part 301 and the mirrored part 303.

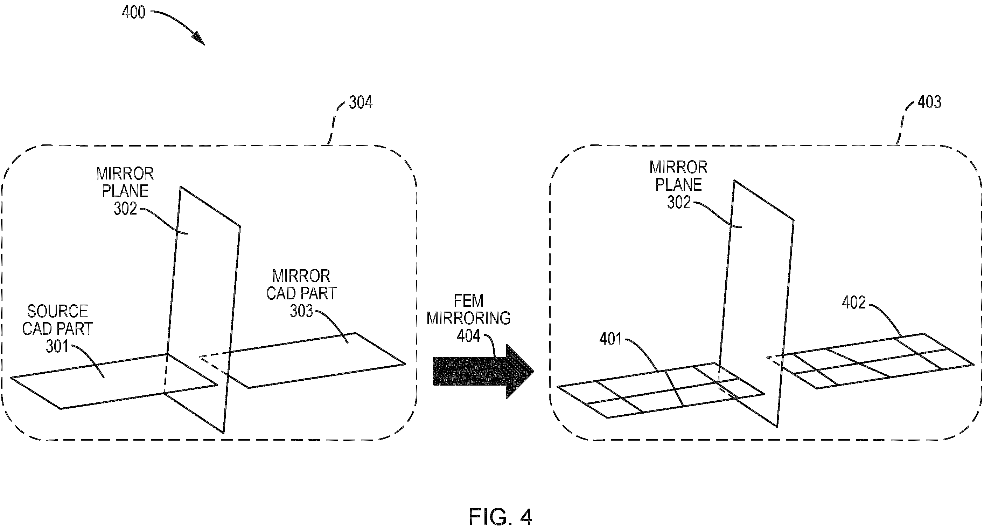

FIG. 4 is a graphical illustration of a method 400, according to an embodiment, of automatically generating a FEM of the CAD assembly 304 utilizing mirroring 404 across a mirror plane 302. The method 400 starts with (1) the CAD assembly 304 from FIG. 3, which includes the source part 301 and mirror part 303, and (2) the mirror plane 302. In turn, FEM mirroring 404 is performed by, first, identifying, e.g., based on user input, source part 301 and meshing the source part 301 to create the source FEM 401. Then, either automatically, or in response to a user input according to embodiments, the mirroring processing 404 mirrors the source FEM 401 across the mirror plane 302 to generate the mirrored FEM 402, thus, creating a FEM 403 of the assembly 304.

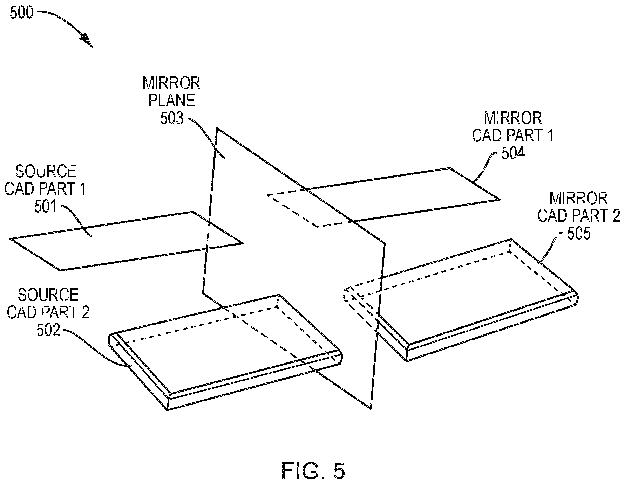

FIG. 5 is a graphical illustration of a method 500 for automatically detecting pairs of mirror parts in a CAD assembly for FEM mirroring based on an identified mirror plane. In the method 500, first, source CAD parts 501 and 502 are created/obtained. In an embodiment, the CAD parts 501 and 502 are created by a user. To continue, mirror plane 503 is identified and, responsive to identifying the mirror plane 503, mirrored CAD parts 504 and 505 are automatically generated across the mirror plane 503.

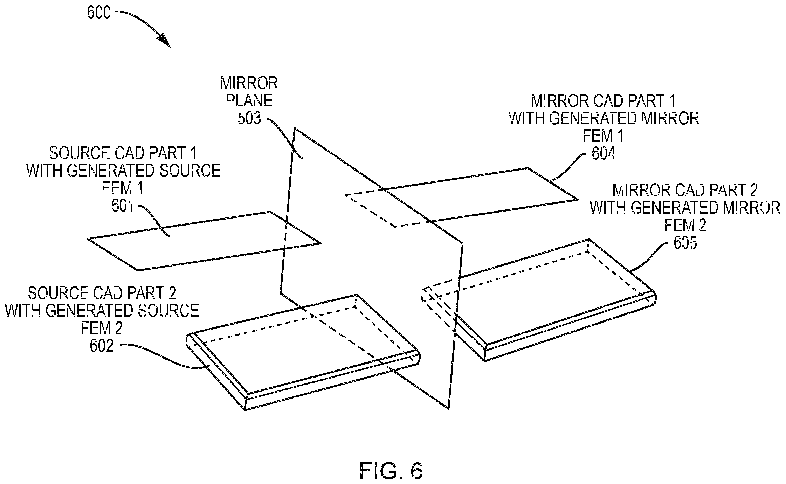

FIG. 6 is a graphical illustration of a method 600 of an embodiment for automatically generating FEMs for both source parts and mirror parts responsive to identifying mirror parts. In the method 600, source CAD parts (501 and 502 from FIG. 5) are meshed resulting in generated source parts with FEMs 601 and 602. In turn, respective FEMs for the mirrored parts (504 and 505 from FIG. 5) are generated by mirroring the source FEMs 601 and 602 across the mirror plane 503 to create mirrored CAD parts with generated mirror FEMs 604 and 605, respectively.

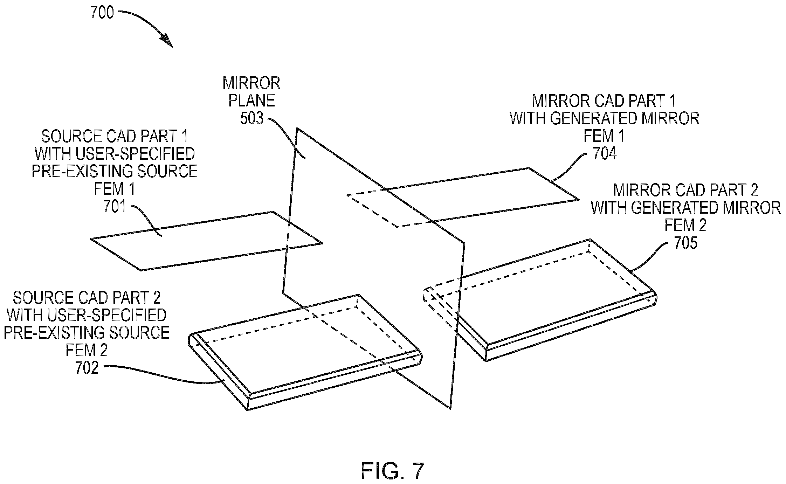

FIG. 7 is a graphical illustration of a method 700 for generating a FEM based upon a user-selected pre-existing FEM. The method 700 embodiment begins with source CAD parts with generated source FEMs 701 and 702. In turn, a user selects a pre-existing source part FEM 701 or 702 and, then, the selected source part FEM is mirrored across the mirror plane 503 to create a mirror part FEM 704 or 705.

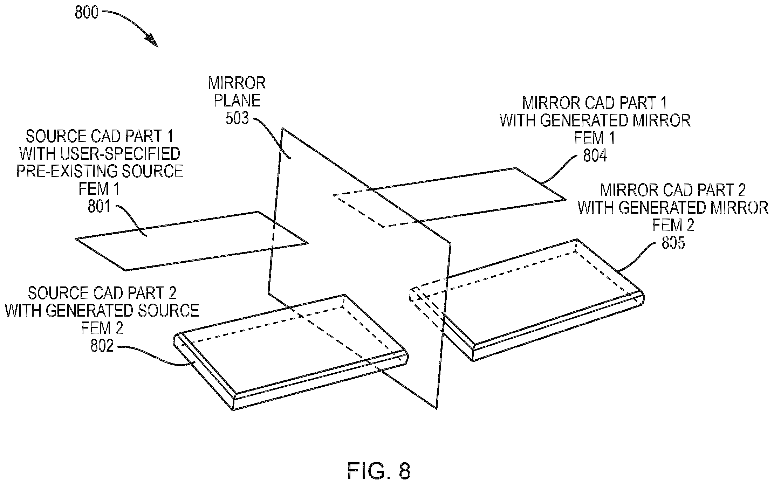

FIG. 8 is a graphical illustration of a method 800, according to an embodiment, for generating FEMs both automatically and based upon user input. In the method 800, the user may select a source CAD part with a pre-existing source FEM 801, and the selected pre-existing source FEM 801 will responsively be mirrored across the mirror plane 503 to create the mirror CAD part with generated mirror FEM 804. Moreover, the method 800 may also automatically generate the FEM for the source CAD part 802, and additionally mirror that automatically generated FEM across the mirror plane 503, to create the mirrored CAD part with generated FEM 805.

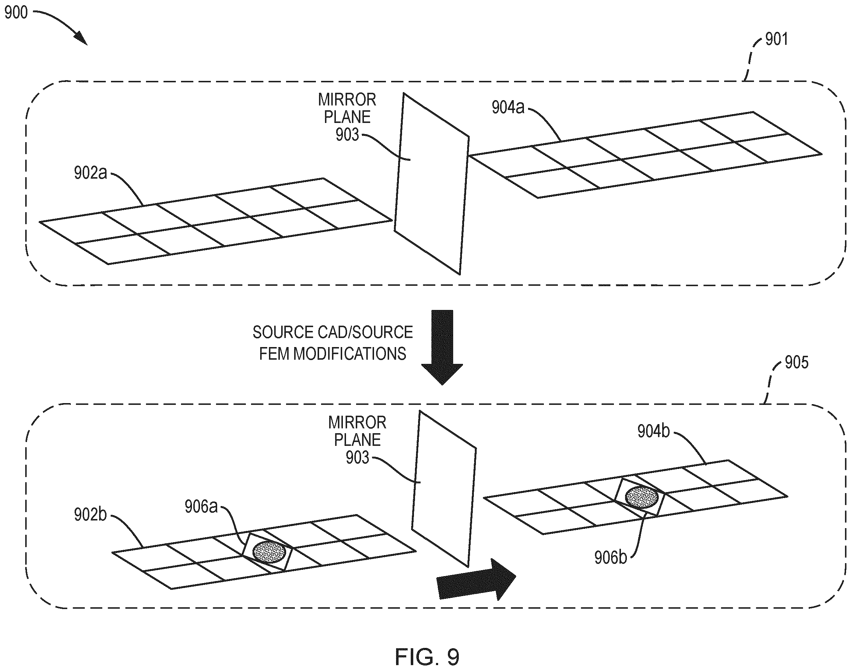

FIG. 9 is a graphical illustration of a method for implementing changes to FEMs according to an embodiment. The method 900 begins at step 901 with a source FEM 902a and a mirrored FEM 904a (this is mirrored across the mirror plane 903). In the method 900, the FEM 902a and FEM 904a are associated, i.e., linked/mapped together in memory, such that changes to one of the FEMs, e.g., 902a/904a is carried out in the other FEM 902a/904. To continue, at step 903, FEM 902b is modified 906a, e.g., by a user and, responsively, this change is carried out 906b across the mirror plane 903 to create the modified FEM 904b. In this way, a FEM, e.g., the mirror FEM 904a, is associative to modifications done to its corresponding source FEM 902a or vice versa. Further, embodiments may also link CAD parts and FEMs such that, responsive to a change in a CAD part, the FEM representing the CAD part is automatically updated and, in response, any linked mirror FEM is also updated.

Embodiments offer substantial benefits to users for automating the modeling of mirror FEMs in assemblies. Embodiments provide improvements in data model, process efficiency, and performance. For example, embodiments allow for increased productivity. In many simulation workflows, about 40% of the global time is spent building the finite element model. For example, users spend significant time finely tuning the mesh, which represents approximately 90 hours for typical automotive body-in-white models made of approximately 300 parts. By employing the automatic FEM mirroring functionality described herein, embodiments provide significant time savings.

Mirroring the FEM also allows for simplicity. Implementing the use of the mirror FEM generation, embodiments leverage the power of modeling and simulation (MODSIM) technology for mirror part detection and, thus, eliminate the need for tagging parts as being symmetric of other parts. Embodiments can automatically establish a link between the source parts and the mirrored parts allowing quick navigation. Embodiments also provide for robust modeling. The generated FEMs can be fully associative to the source FEMs, automatically reflecting changes made to the original model. This allows for less computing power to be required for the simulations, thereby making processes more efficient. Utilizing these embodiments also allows for numerical consistency. The FEM mirroring process ensures an exactly symmetric model, providing a better force flow for crashworthiness simulations.

Amongst other advantages, by efficiently creating FEMs, embodiments may be used in manufacturing and optimization workflows for determining optimized designs of real-world objects, e.g., cars, which are in turn manufactured in accordance with the determined optimized designs. Automating FEM generation greatly accelerates the meshing process (the process of creating FEMs, i.e., meshes) and also allows embodiments to integrate rules-based meshing technology into embodiments. Specifically, the mesh generation described herein may be implemented in accordance with defined rules/parameters, such as meshing with quadratic triangles at a mesh size of 5mm. Automating FEM generation also increases accessibility (no interactive application is required). Embodiments can also function with assemblies to automatically create FEM assemblies. Another advantage of automatically generating FEMs using embodiments is the ability to mesh multiple products without the need to load all of the data that may be related to the geometries and FEMs into computer memory. An assembly typically includes hundreds of geometries representing parts. From a software perspective, loading a geometry involves retrieving all related data, which can consume significant memory and resources. Mirroring process embodiments described herein work without fully loading all data which allows mirror parts to be identified with 'basic loading'. The automated FEM methods described herein can be used with individual products or assemblies and can be used to create an assembled FEM, and to mesh an assembly made of sub-products with three-dimensional (3D) shape representations. Embodiments can also run procedures to optimize geometry and complete other tasks (e.g., changing a geometry from a thin solid to a surface) on a product before meshing.

Using embodiments, once a symmetry plane is defined, symmetric parts can be automatically detected and their FEMs get entirely mirrored within a few seconds.

Further, speeding up and automating the mesh generation process also allows embodiments to speed up optimization methods and more quickly manufacture and create real-world objects. To illustrate, during optimization studies FEMs are modified and, often, the modified FEMs reach a point where they can longer be used and new FEMs must be created. By utilizing embodiments, the new FEMs can be generated more quickly, which ultimately leads to more quickly completing the optimization study, determining an optimized design, and manufacturing a real-world object, e.g., vehicle, with an optimized design. As such, embodiments, can be used in a manufacturing process to manufacture real-world objects. Further, embodiments may begin by measuring or obtaining data regarding a real-world object and creating the CAD model representing the real-world object. This CAD model can, in turn, be used in embodiments to determine improvements to the real-world object and manufacture an improved version, e.g., a version that complies with a new physical behavior requirement, of the real-world object.

### Computer Support

FIG. 10 illustrates a computer network or similar digital processing environment in which embodiments of the present disclosure may be implemented.

Client computer(s)/devices 50 and server computer(s) 60 provide processing, storage, and input/output devices executing application programs and the like. The client computer(s)/devices 50 can also be linked through communications network 70 to other computing devices, including other client devices/processes 50 and server computer(s) 60. The communications network 70 can be part of a remote access network, a global network (e.g., the Internet), a worldwide collection of computers, local area or wide area networks, and gateways that currently use respective protocols (TCP/IP, Bluetooth^{®}, etc.) to communicate with one another. Other electronic device/computer network architectures are suitable.

FIG. 11 is a diagram of an example internal structure of a computer (e.g., client processor/device 50 or server computers 60) in the computer system of FIG. 10. Each computer 50, 60 contains a system bus 79, where a bus is a set of hardware lines used for data transfer among the components of a computer or processing system. The system bus 79 is essentially a shared conduit that connects different elements of a computer system (e.g., processor, disk storage, memory, input/output ports, network ports, etc.) that enables the transfer of information between the elements. Attached to the system bus 79 is an I/O device interface 82 for connecting various input and output devices (e.g., keyboard, mouse, displays, printers, speakers, etc.) to the computer 50, 60. A network interface 86 allows the computer to connect to various other devices attached to a network (e.g., network 70 of FIG. 10). Memory 90 provides volatile storage for computer software instructions 92A and data 94a used to implement an embodiment of the present disclosure. The computer software instructions can implement the methods and operations of methods 200, 300, 400, 500, 600, 700, 800, and/or 900 detailed above. Disk storage 95 provides non-volatile storage for computer software instructions 92B and data 94b used to implement an embodiment of the present disclosure. The computer software instructions can implement the methods and operations of methods 200, 300, 400, 500, 600, 700, 800, and/or 900 detailed above. A central processor unit 84 is also attached to the system bus 79 and provides for the execution of computer instructions.

In one embodiment, the processor routines 92A-B and data 94a-b are a computer program product (generally referenced 92), including a non-transitory computer-readable medium (e.g., a removable storage medium such as one or more DVD-ROM's, CD-ROM's, diskettes, tapes, etc.) that provides at least a portion of the software instructions for an embodiment. The computer program product 92 can be installed by any suitable software installation procedure, as is well known in the art. In another embodiment, at least a portion of the software instructions may also be downloaded over a cable communication and/or wireless connection. In other embodiments, the invention programs are a computer program propagated signal product embodied on a propagated signal on a propagation medium (e.g., a radio wave, an infrared wave, a laser wave, a sound wave, or an electrical wave propagated over a global network such as the Internet, or other network(s)). Such carrier medium or signals may be employed to provide at least a portion of the software instructions for the present invention routines/program 92A-B.

Embodiments or aspects thereof may be implemented in the form of hardware, firmware, or software. If implemented in software, the software may be stored on any non-transient computer readable medium that is configured to enable a processor to load the software or subsets of instructions thereof. The processor then executes the instructions and is configured to operate or cause an apparatus to operate in a manner as described herein.

Further, firmware, software, routines, or instructions may be described herein as performing certain actions and/or functions of the data processors. However, it should be appreciated that such descriptions contained herein are merely for convenience and that such actions in fact result from computing devices, processors, controllers, or other devices executing the firmware, software, routines, instructions, etc.

It should be understood that the flow diagrams, block diagrams, and network diagrams may include more or fewer elements, be arranged differently, or be represented differently. But it further should be understood that certain implementations may dictate the block and network diagrams and the number of block and network diagrams illustrating the execution of the embodiments be implemented in a particular way.

Accordingly, further embodiments may also be implemented in a variety of computer architectures, physical, virtual, cloud computers, and/or some combination thereof, and thus, the data processors described herein are intended for purposes of illustration only and not as a limitation of the embodiments.

While example embodiments have been particularly shown and described, it will be understood by those skilled in the art that various changes in form and details may be made therein without departing from the scope of the embodiments encompassed by the appended claims.

For example, the foregoing description and details of embodiments in the figures reference Applicant-Assignee (Dassault Systemes Americas Corporation) and Dassault Systemes, tools and platforms, for purposes of illustration and not limitation. Other similar tools and platforms are suitable.

The teachings of all patents, published applications and references cited herein are incorporated by reference in their entirety.

## Claims

1. A computer-implemented method of generating a finite element model (FEM), the method comprising, by a processor:
obtaining in memory of the processor: (i) a computer-aided design (CAD) model representing an assembly of parts, and (ii) an indication of a symmetry plane within the CAD model;
from amongst the assembly of parts, identifying a source part and corresponding mirror part, wherein the source part and the mirror part are identified using the obtained CAD model and the indication of the symmetry plane;
meshing the source part to generate a FEM representing the source part; and
mirroring the FEM representing the source part to generate a FEM representing the mirror part.

2. The computer-implemented method of Claim 1, wherein at least one of the meshing and the mirroring are performed automatically responsive to the identifying of the source part and the corresponding mirror part.

3. The computer-implemented method of Claim 1, wherein at least one of the meshing and the mirroring are performed responsive to a user input.

4. The computer-implemented method of Claim 3, wherein the user input is at least one of:
the indication of the symmetry plane;
an indication to perform the obtaining, the identifying, the meshing, and the mirroring; and
an indication of a candidate source part.

5. The computer-implemented method of Claim 4, wherein identifying the source part comprises:
identifying the source part using the indication of the candidate source part.

6. The computer-implemented method of Claim 1, further comprising, at least one of:
associating, in the memory, a representation of the source part in the CAD model and the FEM representing the source part; and
associating, in the memory, a representation of the mirror part in the CAD model and the FEM representing the mirror part.

7. The computer-implemented method of Claim 6, further comprising:
responsive to modifying the representation of the source part in the CAD model, automatically modifying the FEM representing the source part and the FEM representing the mirror part.

8. The computer-implemented method of Claim 6, further comprising:
responsive to modifying the FEM representing the source part, automatically modifying the FEM representing the mirror part.

9. The computer-implemented method of Claim 6, further comprising:
receiving indications of (i) a selected element of the representation of the mirror part in the CAD model and (ii) one or more simulation features to apply to the selected element;
based on the associating, in the memory, of the representation of the mirror part in the CAD model and the FEM representing the mirror part, identifying one or more elements of the FEM representing the mirror part corresponding to the selected element of the representation of the mirror part in the CAD model;
applying the one or more simulation features to the identified one or more elements of the FEM representing the mirror part; and
performing a simulation utilizing the FEM representing the mirror part with the one or more features applied.

10. The computer-implemented method of Claim 6, wherein associating, in the memory, the representation of the mirror part in the CAD model and the FEM representing the mirror part comprises:
linking, in the memory, (i) the representation of the mirror part in the CAD model and (ii) the representation of the source part in the CAD model;
linking, in the memory, (i) the representation of the source part in the CAD model and (ii) elements of the FEM representing the source part; and
linking, in the memory, (i) the elements of the FEM representing the source part and (ii) elements of the FEM representing the mirror part.

11. A computer program for generating a finite element model (FEM) comprising instructions which, when executed by a computer system, cause the computer system to perform the method according to any one of Claims 1 to 10.

12. A computer-readable data storage medium having recorded thereon the computer program of Claim 11.

13. A system for generating a finite element model (FEM), the system comprising:
a processor; and
a memory having recorded thereon the computer program of Claim 11.
